# EUROPÄISCHE PATENTSCHRIFT

(11) **EP 1 591 750 B1**
(45) Veröffentlichungstag und Bekanntmachung des Hinweises auf die Patenterteilung: **13.04.2016**
(21) Anmeldenummer: 04009789.1
(22) Anmeldetag: 26.04.2004
(51) Int. Cl.: C23C 14/54, C23C 14/56, G01B 11/06

(54) **Verfahren und Vorrichtung zur Regelung der Dicke einer Beschichtung auf einem in seiner Längsrichtung bewegten Band**
Method and apparatus for controlling the thickness of a coating on a ribbon moved in its longitudinal direction
Procédé et appareil pour contrôler l'épaisseur d'une couche sur un ruban en mouvement dans sa direction longitudinale

(43) Veröffentlichungstag der Anmeldung: 02.11.2005
(73) Patentinhaber: Applied Materials GmbH & Co. KG, 63755 Alzenau (DE)
(72) Erfinder: Lotz, Hans-Georg, 63584 Gründau-Rothenbergen (DE); Sauer, Peter, 36381 Schlüchtern (DE); Steiniger, Gerhard, 63549 Ronneburg (DE); Hoffmann, Gerd, 63486 Bruchköbel (DE); Ludwig, Rainer, 63768 Hösbach (DE)
(74) Vertreter: Zimmermann & Partner Patentanwälte mbB

(56) Entgegenhaltungen:
- WO-A-00/12958
- DE-A- 3 330 092
- DE-A- 3 406 645
- DE-C- 10 019 258
- US-B1- 6 271 047

## Beschreibung

Die Erfindung betrifft ein Verfahren und eine Vorrichtung zur Regelung der Schichtdicke eines Beschichtungsmaterials.

Gläser, Folien und andere Substrate werden mit dünnen Schichten versehen, um ihnen besondere Eigenschaften zu verleihen. Beispielsweise werden solche Schichten auf Kunststofffolien aufgebracht, um diese gasdicht zu machen.

Für das Aufbringen dieser Schichten auf die Substrate sind verschiedene Verfahren bekannt, von denen nur das Aufsputtern und das Aufdampfen erwähnt seien. Das Aufdampfen hat gegenüber dem Sputtern den Vorteil, dass die Schichten mit 10- bis 100-facher Geschwindigkeit aufgebracht werden können.

Es ist bereits ein Verfahren zum Verdampfen von Materialien mittels eines Elektronenstrahls bekannt (EP 0 910 110 A2). Hierbei geht es jedoch um die gezielte Steuerung des Elektronenstrahls und nicht um die Messung einer aufgedampften Schicht.

Des Weiteren wird auf ein aus der DE 33 30 092 A1 bekanntes Verfahren zum Einstellen der örtlichen Verdampfungsleistung an Verdampfern in Vakuumaufdampfprozessen verwiesen.

Weiterhin ist es bekannt, die Schichtdicke dadurch zu bestimmen, dass die optische Absorption gemessen wird. Bei dickeren und schwach absorbierenden Schichten ist diese Messmethode jedoch nicht einsetzbar, weil Interferenzeffekte ein möglicherweise vorhandenes schwaches Absorptionssignal überlagern (Quality Control and Inline Optical Monitoring for Opaque Film, AIMCAL Fall Conference, October 28, 2003).

Der Erfindung liegt deshalb die Aufgabe zugrunde, eine Regelung für ein Beschichtungsverfahren zu schaffen, mit dem es möglich ist, die Dicke von weitgehend absorptionsfreien Beschichtungsmaterialien über die Breite eines Substrats konstant zu halten.

Diese Aufgabe wird gemäß den Merkmalen des Patentanspruchs 1 sowie des Patentanspruchs 13 gelöst.

Die Erfindung betrifft somit ein Verfahren und eine Vorrichtung zur Regelung der Schichtdicke eines Beschichtungsmaterials auf einem in seiner Längsrichtung bewegten Band. Hierbei wird über die Breite des Bands an mehreren Stellen die Dicke der Schicht durch Messung der Reflexion gemessen und eine Beschichtungsanlage derart geregelt, dass die Dicke der Schicht über die Breite des Bands konstant ist. Ferner wird die Transmission des Beschichtungsmaterials gemessen und aufgrund der gemessenen Transmission die Zusammensetzung der Schicht geregelt. Die Dickenregelung kann dabei mittels Intensitätsveränderung von Elektronenstrahlen erreicht werden, welche ein Beschichtungsmaterial verdampfen. Es können aber auch mehrere über die Breite des Bands verteilte Verdampferschiffchen individuell so aufgeheizt werden, dass sich eine gleichmäßige Beschichtung über die Breite des Bands ergibt. Mit Hilfe eines zusätzlichen Transmissions-Messgeräts kann auch die Zusammensetzung des Beschichtungsmaterials über die Breite des Bands konstant geregelt werden.

Der mit der Erfindung erzielte Vorteil besteht insbesondere darin, dass bei einer Beschichtung mittels Elektronenstrahl-Verdampfer der Elektronenstrahl über die Breite eines Substrats derart geregelt werden kann, dass sich über die gesamte Breite dieses Substrats eine gleichmäßige Verteilung des Beschichtungsmaterials ergibt.

Bei der Messung der Dicke von weitgehend absorptionsfreiem Beschichtungsmaterial wird von der Eigenschaft dielektrischer Schichten Gebrauch gemacht, dass durch Interferenzeffekte im optischen Spektrum Maxima und Minima entstehen, die ein Maß für die optische Schichtdicke darstellen.

Mit der gemessenen Schichtdicke kann der Beschichtungsprozess gesteuert werden, beispielsweise die Intensität und/oder der Ablenkungswinkel eines Elektronenstrahls, der auf ein zu verdampfendes Material trifft.

Ein Ausführungsbeispiel der Erfindung ist in den Zeichnungen dargestellt und wird im Folgenden näher beschrieben. Es zeigen:
Fig. 1 eine perspektivische Ansicht einer Bedampfungsanlage für Kunststofffolien;
Fig. 2 eine Detaildarstellung aus der Fig. 1, die eine beschichtete Folie zeigt;
Fig. 3 eine Prinzipdarstellung von Weißlichtinterferenzen;
Fig. 4 Interferenzen einer Lichtwelle, die an einer Oberfläche und an einer Grenzschicht reflektiert wird;
Fig. 5 eine Reflexionskurve einer Beschichtung in Abhängigkeit von der Lichtwellenlänge;
Fig. 6 eine weitere Reflexionskurve einer Beschichtung in Abhängigkeit von der Lichtwellenlänge;
Fig. 7 eine weitere Reflexionskurve einer Beschichtung in Abhängigkeit von der Lichtwellenlänge;
Fig. 8 mehrere Reflexionskurven, von denen jede für einen anderen Ort eines beschichteten Substrats gilt.

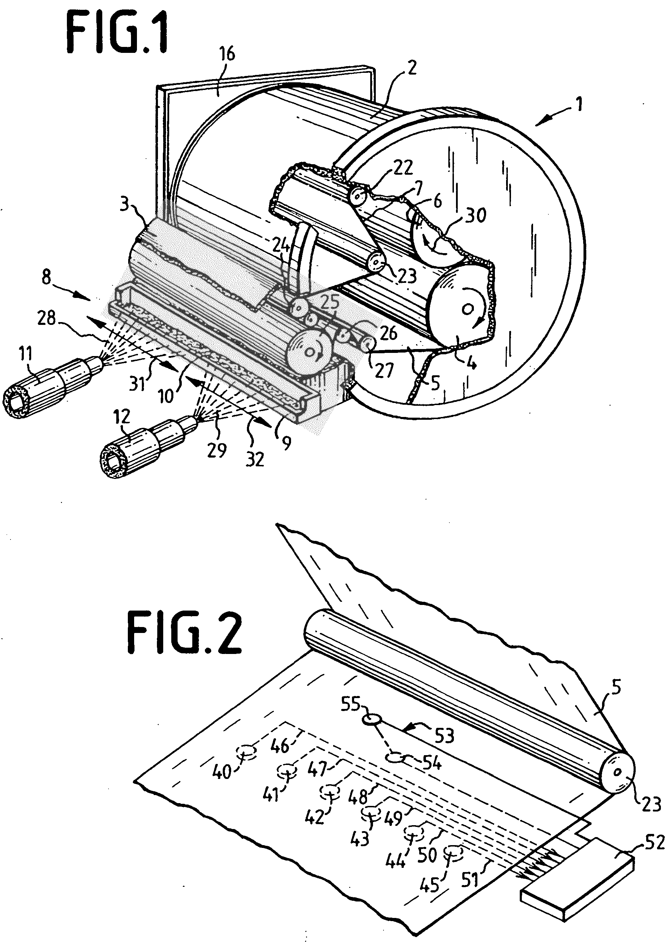

In der Fig. 1 ist eine perspektivische Ansicht einer erfindungsgemäßen Hochraten-Bedampfungsanlage 1 gezeigt. Diese Anlage weist zwei Kammern 2, 3 auf, von denen die eine Kammer 2 eine Abwickelrolle 4 für eine unbeschichtete Kunststofffolie 5 sowie eine Aufwickelrolle 6 für eine beschichtete Kunststofffolie 7 enthält, während die andere Kammer 3 mit der eigentlichen Bedampfungsanlage 8 ausgerüstet ist. Von der zweiten Kammer 3 ist nur ein kleiner Teil zu erkennen; der größere Teil ist weggelassen, um die Bedampfungsanlage 8 besser zu erkennen. Diese Bedampfungsanlage 8 besteht im Wesentlichen aus einem Tiegel 9 mit zu verdampfendem Material 10 und zwei Elektronenstrahlkanonen 11, 12.

Die beiden Kammern 2, 3 sind durch kleine Schlitze miteinander verbunden, die notwendig sind, um die zu beschichtende Folie 5 über Umlenkwalzen 22 bis 27 von einer Kammer 2 bzw. 3 in die jeweils andere Kammer 3 bzw. 2 zu bringen. Die Druckdifferenz zwischen beiden Kammern 2, 3 beträgt etwa zwei Zehnerpotenzen.

Nicht dargestellt ist eine magnetische Ablenkeinheit, welche die waagrecht einfallenden Elektronenstrahlen 28, 29 der Elektronenstrahlkanone 11, 12 senkrecht auf das zu verdampfende Material 10 umlenkt. Mit 16 ist eine Platte bezeichnet, die Teil einer Vorrichtung ist, die mit wesentlichen Teilen der gesamten Anlage in Verbindung steht. Diese Teile können aus der Kammer 2 herausgefahren werden, sodass die Kammer leicht zu warten ist.

Die Beschichtung der Kunststofffolie 5 in der Anlage 1 wird im Folgenden beschrieben.

Ein nicht dargestellter Antriebsmotor treibt die Aufwickelwalze 6 in Richtung des Pfeils 30 an, in welche das Ende der beschichteten Folie 7 eingehängt ist. Hierdurch wird die unbeschichtete Folie 5 von der Abwickelwalze 4 abgewickelt und über die Umlenkrollen 26, 27 auf die Beschichtungsrolle 25 gegeben. Dort wird die Folie 5 mit Materialteilchen bombardiert, die aufgrund der Erwärmung des Beschichtungsmaterials 10 durch die Elektronenstrahlen 28, 29 verdampfen und sich auf der Folie 5 niederschlagen. Die Elektronenstrahlen 28, 29 werden - was durch die Pfeile 31, 32 angedeutet ist - wenigstens in einer Richtung hin- und herbewegt, sodass das Material 10 über die ganze Länge des Tiegels 9 verdampft wird.

Dadurch, dass das Beschichtungsmaterial 10 über die ganze Breite der Folie 7 vorgesehen ist, kann jedem Punkt auf der Breiten-Linie eine Verdampfungsintensität zugeordnet werden, d. h. die Verdampfungsrate des Beschichtungsmaterials ist in Richtung der Folienbreite durch eine entsprechende Beeinflussung des Ablenksystems und der Strahlintensität des Elektronenstrahls einstellbar.

Statt eines Tiegels 9 können auch mehrere neben einander angeordnete Verdampferschiffchen vorgesehen werden, wie sie in der DE 40 27 034 beschrieben sind.

In der Fig. 2 ist ein Teilbereich aus der Fig. 1 in vergrößertem Maßstab dargestellt. Man erkennt hierbei die Walze 23 sowie die Folie 5, die durch die Walze 23 geführt wird. Die Folie 5 ist auf ihrer Unterseite bereits beschichtet. Die Dicke dieser Schicht wird mittels mehrerer Reflexionsmessgeräte 40 bis 45 gemessen. Diese weisen jeweils einen Lichtsender und einen Lichtempfänger auf. Die gemessenen reflektiven Lichtsignale werden in elektrische Signale umgewandelt und über Leitungen 46 bis 51 auf eine Auswerteschaltung 52 gegeben. Die Energieversorgungsleitungen für die Reflexionsmessgeräte 40 bis 45 sind in der Fig. 2 nicht dargestellt.

Die Auswerteschaltung 52 steht mit einer nicht dargestellten Steuerung für die Elektronenstrahlen 28, 29 in Verbindung. Die Intensität bzw. der Ablenkwinkel dieser Elektronenstrahlen wird in Abhängigkeit von der gemessenen Schichtdicke geregelt. Ist die Schichtdicke an einer bestimmten Stelle über der Breite der Folie 5 zu gering, wird die Verdampfung unterhalb dieser Stelle erhöht, sodass die Schichtdicke dort zunimmt.

Anstelle von Elektronenstrahlen können auch mehrere hintereinander angeordnete Verdampferschiffchen vorgesehen sein, die einzeln aufheizbar sind, sodass entlang der Breite der Folie 5 die Verdampfung variabel ist.

Zusätzlich zu den Reflexionsmessgeräten 40 bis 45 kann noch ein Transmissionsmessgerät 53 vorgesehen sein, das einen optischen Sender 54 unterhalb der Folie 5 und einen optischen Empfänger 55 oberhalb der Folie enthält. Sender 54 und Empfänger 55 sind ebenfalls mit der Auswerteschaltung 52 verbunden, die auch als Energieversorgung dient. Mit einer zusätzlichen monochromen Transmissionsmessung im kurzwelligen Bereich (< 450 nm, typisch: Wellenlängen zwischen 350 - 400 nm) kann man feststellen, ob noch Restabsorption in der Schicht vorhanden ist. Dies zeigt sich durch unterschiedliche Transmissionswerte. So könnte die Schicht z. B. am linken Rand der Folie eine Transmission (gemessen bei 360 nm) von 5 % haben, in der Mitte 8 % und am rechten Rand der Folie 7 %. Durch gezielte Zugabe von Sauerstoff kann die Transmission der Folie auf einen konstanten Wert von z. B. 8 % an allen Messstellen gebracht werden. Dadurch ist gewährleistet, dass der Oxidationszustand der Schicht an allen Stellen der Folie gleich ist. Dieses Verfahren (für schwach absorbierende Schichten) setzt voraus, dass die Schichtdicke über die Folienbreite konstant ist. Es kann in Verbindung mit einer Regelung gemäß DE 197 45 771 A1 eingesetzt werden.

Das Reflexionsmesssystem führt eine automatische spektrale Positionsbestimmung der Extremwerte durch. Die spektralen Positionen der Extremwerte dienen als Stellgröße für die Steuerung der Elektronenstrahlen. Mittels einer zusätzlichen Transmissionsmessung, für welche das Transmissionsmessgerät 53 vorgesehen ist, können auch Informationen über eventuelle Restabsorptionen der Schicht erhalten werden. Die Absorption ergibt sich aus der Formel A = 100 - R - T, wobei R = Reflexion und T = Transmission. Der Wert der Absorption A dient als Stellgröße für den Reaktivgaseinlass des Beschichtungsprozesses, wobei der Sollwert für A typischerweise im Bereich zwischen 0 % und 10 % liegt. Es ist damit möglich, die Zusammensetzung der Schicht über die Breite des Bands konstant zu regeln.

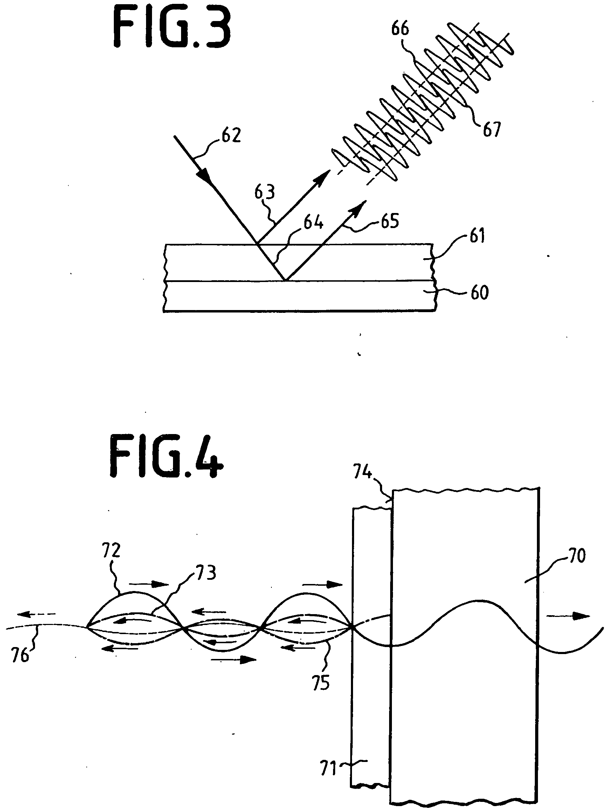

Die Fig. 3 zeigt das Prinzip von Weißlichtinterferenzen. Hierbei ist auf einem Substrat 60 eine Schicht 61 mit der geometrischen Dicke D aufgetragen und ein Weißlicht-Strahl 62 fällt unter einem Winkel α auf die Oberfläche der Schicht 61. Ein Teil des Lichtstrahls 62 wird dabei als Lichtstrahl 63 reflektiert, während ein anderer Teil 64 des Lichtstrahls 62 die Schicht 61 durchdringt und erst an der Oberfläche des Substrats 60 als Strahl 65 reflektiert wird. Die beiden Lichtstrahlen 63, 65 sind auch als Lichtwellen 66, 67 dargestellt. Diese Lichtwellen 66, 67 sind sinusförmig und können sich auslöschen oder verstärken.

In der Fig. 4 ist das Interferenzprinzip nicht anhand eines Lichtstrahls, sondern einer Lichtwelle dargestellt, die überdies nicht in einem Winkel, sondern senkrecht auf ein reflektierendes Mittel einfällt. Auf einer Glasplatte 70 mit einem Brechungsindex von n = 1,52 ist eine Schicht 71 aus MgF₂ aufgebracht, die einen Brechungsindex von n = 1,38 hat. Diese Schicht 71 hat eine Dicke von einem Viertel der Wellenlänge des auftreffenden Lichts (λ/4). Die auftreffende Lichtwelle 72 wird an der Oberfläche der Schicht 71 teilweise reflektiert. Die reflektierte Lichtwelle 73 hat eine geringere Amplitude als die einfallende Lichtwelle 72.

An der Oberfläche 74 der Glasplatte 70 wird die Lichtwelle 72 ebenfalls reflektiert und überlagert als Lichtwelle 75 die Lichtwelle 73. Da beide Lichtwellen 73, 75 um 180 Grad phasenverschoben sind, löschen sie sich bei gleicher Amplitude gegenseitig aus. Bei geringfügig abweichender Amplitude ergibt sich als Resultierende die Lichtwelle 76 mit sehr kleiner Amplitude. Man erkennt hieraus, dass eine λ/4-Schicht als Antireflexionsschicht aufgefasst werden kann.

Die gegenseitige Auslöschung der Wellen 73 und 75 erfolgt nur, wenn die Schicht 71 eine Dicke von λ/4 hat. Hat sie eine andere Dicke, nimmt die Amplitude der resultierenden Welle 76 zu. Kennt man die Lichtwellenlänge, so kann man über die Gleichung n. d = λ/4 auf die Dicke der Schicht schließen - wobei d die geometrische Dicke und n der Brechungsindex ist, indem man das Maximum oder Minimum der Amplitude der reflektierten Lichtwelle 76 ermittelt. Stellt man beispielsweise bei λ = 480 nm ein Minimum fest, so ist die Schicht 120 nm dick. Weitere Zusammenhänge zwischen den physikalischen Größen dünner Schichten und der Lichtwellenlänge können der DE 39 36 541 C2 entnommen werden.

Um feststellen zu können, bei welcher Wellenlänge die Amplitude des reflektierten Lichts ein Minimum hat, wird die Wellenlänge des auf die Schicht 71 gegebenen Lichts variiert, d. h. das Licht durchläuft die Wellenlänge des sichtbaren Bereichs von etwa 380 bis 780 nm. Mit Hilfe von Spektralfotometern lassen sich solche Wellenlängenänderungen durchführen (vgl. z. B. Naumann/Schröder: Bauelemente der Optik, 5. Auflage, 1987, 16.2, S. 483 bis 487; DE 34 06 645 C2).

Wenn - wie in Fig. 2 gezeigt - an mehreren Stellen über die Breite einer Folie die Reflexion gemessen wird, ist es zweckmäßig, ein Spektralfotometer mit mehreren Glasfaserleitungen vorzusehen, die alle von derselben Lichtquelle gespeist werden. Es können dann Reflexionskurven für mehrere Stellen mit nur einer Lichtquelle gemessen werden.

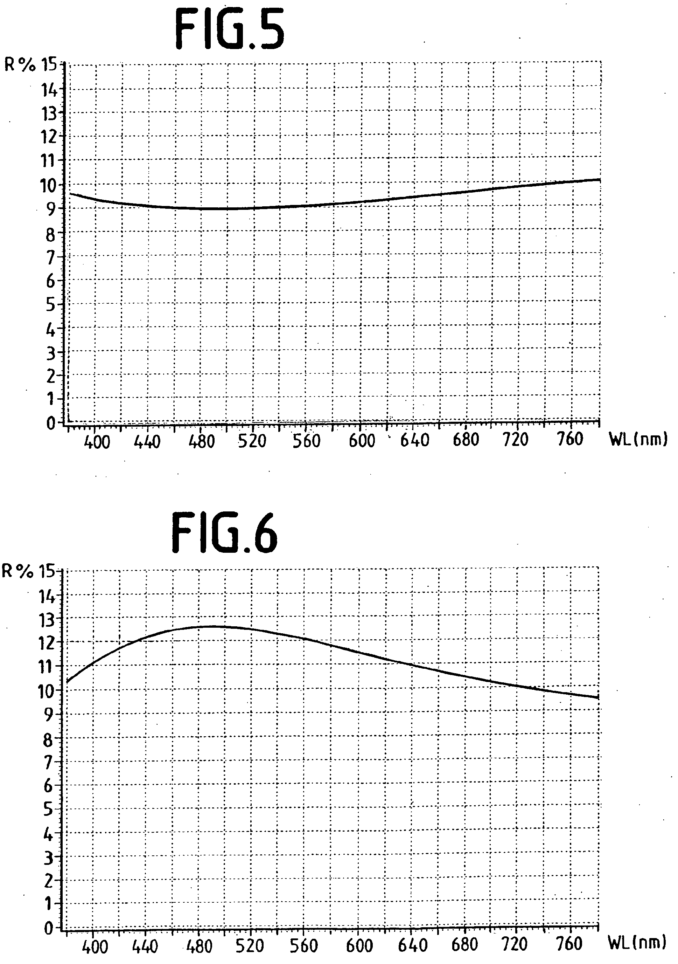

In der Fig. 5 ist der Reflexionsfaktor einer Oxidschicht, Al₂O₃, und einer PET-Folie in Prozent über dem Spektrum von 380 bis 780 nm aufgetragen. Man erkennt hierbei, dass das Minimum bei 500 nm liegt, woraus sich eine Schichtdicke von 125 nm errechnet.

Die Fig. 6 zeigt eine weitere Kurvendarstellung, bei welcher der Reflexionsfaktor in Prozent über der Wellenlänge gezeigt ist. Man erkennt hierbei, dass der Reflexionsfaktor etwa bei 480 nm ein Maximum besitzt. Dies bedeutet, dass bei 480 nm die reflektierten Lichtwellenlängen am wenigstens interferieren. Dieser Effekt tritt dann auf, wenn die Schichtdicke d = λ/2 ist, d. h. 240 nm.

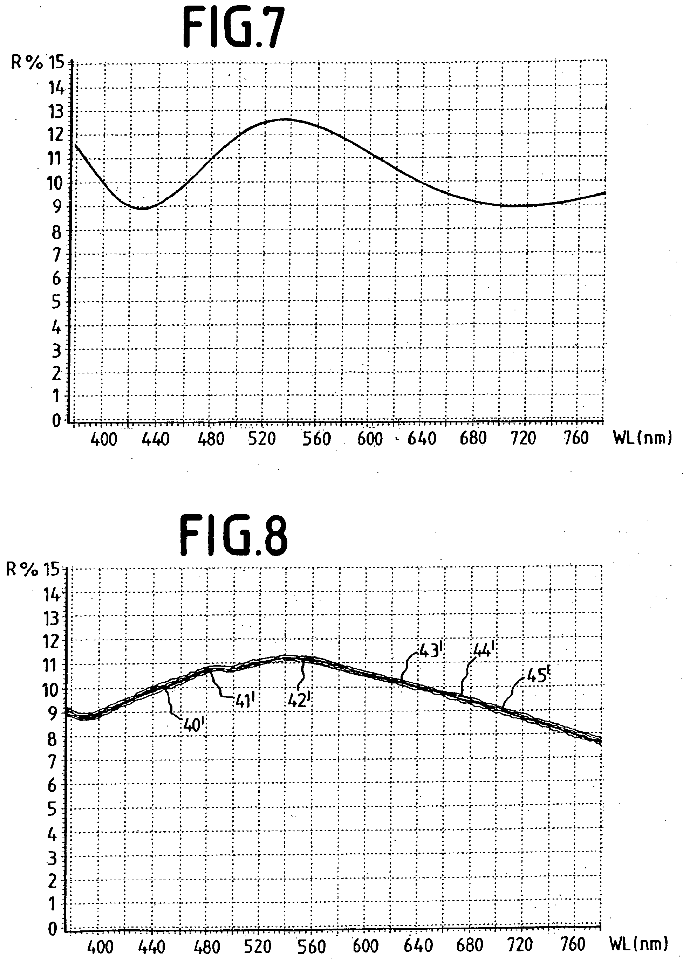

In der Fig. 7 ist eine weitere Reflexionskurve dargestellt, die jedoch ein Maximum und zwei Minima aufweist. Beide Minima bzw. das Maximum können zur Schichtdickenmessung verwendet werden.

Die Fig. 8 zeigt sechs Reflexionskurven 40' bis 45' in Abhängigkeit von den jeweiligen Wellenlängen, wobei die Reflexionskurven 40' bis 45' den jeweiligen Sensoren 40 bis 45 zugeordnet sind. Diese Kurven beziehen sich auf eine ca. 170 nm dicke Al₂O₃-Schicht auf PET-Folie, die durch einen Verdampfungsprozess von Aluminium mit Sauerstoff als Reaktivgas hergestellt wurde. Die Kurven liegen bereits übereinander, weil die Regelung der Elektronenstrahlverdampfer die Verdampfungsleistung entsprechend optimiert hat.

## Patentansprüche

1. Verfahren zur Regelung der Schichtdicke eines Beschichtungsmaterials auf einem in seiner Längsrichtung bewegten Band, wobei über die Breite des Bands an mehreren Stellen die Dicke der Schicht durch Messung der Reflexion gemessen wird und eine Beschichtungsanlage derart geregelt wird, dass die Dicke der Schicht über die Breite des Bands konstant ist, und wobei zusätzlich die Transmission des Beschichtungsmaterials gemessen wird und aufgrund der gemessenen Transmission die Zusammensetzung der Schicht geregelt wird.

2. Verfahren nach Anspruch 1, wobei das Beschichtungsmaterial weitgehend absorptionsfrei ist.

3. Verfahren nach Anspruch 1 und Anspruch 2, wobei die Schichtdicke des weitgehend absorptionsfreien Beschichtungsmaterials durch folgende Schritte ermittelt wird:
a) es wird ein Lichtstrahl mit variabler Lichtwellenlänge auf die Oberfläche des Beschichtungsmaterials gerichtet;
b) es wird die Reflexion des Lichtstrahls von der Oberfläche des Beschichtungsmaterials in Abhängigkeit von der Lichtwellenlänge gemessen;
c) es werden die durch Interferenzeffekte im reflektierten variablen Lichtstrahl vorhandenen, von der Lichtwellenlänge abhängigen Maxima und/oder Minima ermittelt.

4. Verfahren nach Anspruch 3, wobei bei einem Maximum oder Minimum die Schichtdicke d aus der Gleichung n . d = lambda /4 errechnet wird, wobei lambda die Lichtwellenlänge ist, bei welcher das Maximum oder Minimum auftritt, und n der Brechungsindex bedeutet.

5. Verfahren nach einem oder nach mehreren der vorhergehenden Ansprüche, wobei die Beschichtung durch Aufdampfen des Beschichtungsmaterials erfolgt.

6. Verfahren nach Anspruch 5, wobei das Beschichtungsmaterial durch eine ortsabhängige Aufheizung von Verdampferschiffchen verdampft wird.

7. Verfahren nach Anspruch 5, wobei das Beschichtungsmaterial durch Elektronenstrahlen verdampft wird und auf das zu beschichtende Band gelangt.

8. Verfahren nach Anspruch 7, wobei die Elektronenstrahlen aufgrund der gemessenen Schichtdicke derart beeinflusst werden, dass sich eine gleichmäßige Schichtdicke über die Breite des Bands ergibt.

9. Verfahren nach Anspruch 1, wobei aufgrund der gemessenen Transmission ein Reaktivgaseinlass geregelt wird.

10. Verfahren nach den Ansprüchen 1 und 9, wobei aufgrund der gemessenen Transmission die Zusammensetzung der Schicht über die Breite des Bands konstant geregelt wird.

11. Verfahren nach einem oder nach mehreren der vorhergehenden Ansprüche, wobei das verdampfte Material Aluminium und das Reaktivgas Sauerstoff ist.

12. Verfahren nach Anspruch 1, wobei die Zusammensetzung der Schicht konstant geregelt wird.

13. Vorrichtung zur Durchführung des Verfahrens nach Anspruch 1, umfassend mehrere über die Breite einer zu beschichtenden Folie (5) vorgesehene Reflexionsmessgeräte (40 bis 45);
eine Auswerteschaltung (52) zur Auswertung der von den Reflexionsmessgeräten (40 bis 45) empfangenen Signale;
eine Schaltungsanordnung für die Steuerung der Intensität und des Ablenkungswinkels eines Elektronenstrahls (28, 29) oder der Heizleistung für Verdampferschiffchen, die zum Verdampfen eines Beschichtungsmaterials vorgesehen sind, und
ein Transmissionsmessgerät (54, 55), das zur Regelung der Zusammensetzung der Schicht dient.

14. Vorrichtung nach Anspruch 13, wobei die Reflexionsmessgeräte (40 bis 45) mit einer gemeinsamen Lichtquelle über Glasfaserleitungen in Verbindung stehen.

## Claims

1. Method for controlling the layer thickness of a coating material on a ribbon moved in its longitudinal direction, wherein the layer's thickness is measured at several points across the ribbon's width by measuring the reflection, and a coating plant is controlled such that the layer's thickness is constant across the ribbon's width, and wherein the transmission of the coating material is measured in addition, and the layer's composition is controlled based on the measured transmission.

2. Method according to claim 1, wherein the coating material is largely absorption-free.

3. Method according to claim 1 and claim 2, wherein the layer thickness of the largely absorption-free coating material is obtained by the following steps:
a) a light beam having a variable wavelength of light is directed onto the surface of the coating material;
b) the reflection of the light beam from the coating material's surface is measured as a function of the wavelength of light;
c) maximum and/or minimum values present within the reflected variable light beam due to interference effects and depending on the wavelength of light are obtained.

4. Method according to claim 3, wherein at a maximum or minimum value, the layer thickness d is calculated from the equation n . d = lambda /4, wherein lambda is the wavelength of light, at which the maximum or minimum value occurs, and n represents the refraction index.

5. Method according to any one of the preceding claims, wherein the coating is performed by vapor-depositing the coating material.

6. Method according to claim 5, wherein the coating material is vaporized by a position-dependent heating of evaporator shuttles.

7. Method according to claim 5, wherein the coating material is vaporized by electron beams and gets onto the ribbon to be coated.

8. Method according to claim 7, wherein the electron beams are influenced based on the measured layer thickness such that a uniform layer thickness comes about across the ribbon's width.

9. Method according to claim 1, wherein a reactive gas inflow is controlled based on the measured transmission.

10. Method according to claims 1 and 9, wherein, based on the measured transmission, the layer's composition is controlled to be constant across the ribbon's width.

11. Method according to one or more of the preceding claims, wherein the vaporized material is aluminum and the reactive gas is oxygen.

12. Method according to claim 1, wherein the layer's composition is controlled to be constant.

13. Apparatus for implementing the method according to claim 1, comprising
a plurality of reflection measuring devices (40 to 45) provided across the width of a film (5) to be coated;
an evaluating circuit (52) for evaluating the signals received from the reflection measuring devices (40 to 45);
a circuit arrangement for controlling the intensity and deflection angle of an electron beam (28, 29) or the heating performance of evaporator shuttles provided for vaporizing a coating material, and
a transmission measuring device (54, 55) serving the purpose of controlling the layer's composition.

14. Device according to claim 13, wherein the reflection measuring devices (40 to 45) are in communication with a common light source via fiber optic cables.

## Revendications

1. Procédé destiné à réguler l'épaisseur de couche d'un matériau de revêtement sur un ruban en mouvement dans sa direction longitudinale, sachant que l'épaisseur de la couche est mesurée en plusieurs points sur la largeur du ruban par mesure de la réflexion et qu'une installation de revêtement est régulée de telle façon que l'épaisseur de la couche soit constante sur la largeur du ruban, et sachant qu'en outre la transmission du matériau de revêtement est mesurée et que la composition de la couche est régulée sur la base de la transmission mesurée.

2. Procédé selon la revendication 1, sachant que le matériau de revêtement est sensiblement non absorbant.

3. Procédé selon la revendication 1 et la revendication 2, sachant que l'épaisseur de couche du matériau de revêtement sensiblement non absorbant est déterminée par les étapes suivantes :
a) un faisceau lumineux à longueur d'onde lumineuse variable est dirigé sur la surface du matériau de revêtement ;
b) la réflexion du faisceau lumineux depuis la surface du matériau de revêtement est mesurée en fonction de la longueur d'onde lumineuse ;
c) les maxima et/ou minima présents du fait d'effets d'interférence dans le faisceau lumineux variable réfléchi, en fonction de la longueur d'onde lumineuse, sont déterminés.

4. Procédé selon la revendication 3, sachant que, pour un maximum ou minimum, l'épaisseur de couche d est calculée à partir de l'équation n . d = lambda /4, sachant que lambda est la longueur d'onde lumineuse à laquelle le maximum ou minimum survient, et n représente l'indice de réfraction.

5. Procédé selon une ou selon plusieurs des revendications précédentes, sachant que le revêtement s'effectue par dépôt en phase vapeur du matériau de revêtement.

6. Procédé selon la revendication 5, sachant que le matériau de revêtement est vaporisé par un chauffage de nacelles de vaporisation qui dépend de l'emplacement.

7. Procédé selon la revendication 5, sachant que le matériau de revêtement est vaporisé et parvient sur le ruban à revêtir par faisceaux d'électrons.

8. Procédé selon la revendication 7, sachant que les faisceaux d'électrons sont influencés de telle façon sur la base de l'épaisseur de couche mesurée qu'il en résulte une épaisseur de couche régulière sur la largeur du ruban.

9. Procédé selon la revendication 1, sachant qu'une admission de gaz réactif est régulée sur la base de la transmission mesurée.

10. Procédé selon les revendications 1 et 9, sachant que la composition de la couche est régulée de manière constante sur la largeur du ruban sur la base de la transmission mesurée.

11. Procédé selon une ou selon plusieurs des revendications précédentes, sachant que le matériau vaporisé est de l'aluminium et le gaz réactif est de l'oxygène.

12. Procédé selon la revendication 1, sachant que la composition de la couche est régulée de manière constante.

13. Dispositif destiné à exécuter le procédé selon la revendication 1, comprenant plusieurs appareils de mesure de réflexion (40 à 45) prévus sur la largeur d'une feuille (5) à revêtir ;
un circuit d'évaluation (52) destiné à évaluer les signaux reçus par les appareils de mesure de réflexion (40 à 45) ;
un agencement de circuit pour la commande de l'intensité et de l'angle de déviation d'un faisceau d'électrons (28, 29) ou de la puissance de chauffage pour des nacelles de vaporisation qui sont prévues pour la vaporisation d'un matériau de revêtement, et
un appareil de mesure de transmission (54, 55) qui sert à réguler la composition de la couche.

14. Dispositif selon la revendication 13, sachant que les appareils de mesure de réflexion (40 à 45) sont en relation avec une source lumineuse commune via des lignes à fibres de verre.
